(19) Europäisches Patentamt / European Patent Office / Office européen des brevets

(11) **EP 4 447 644 B1**

(12) **EUROPEAN PATENT SPECIFICATION**

(45) Date of publication and mention
of the grant of the patent:
**17.12.2025  Bulletin 2025/51**

(51) International Patent Classification (IPC):
**H10N 50/01** (2023.01)       **H10N 50/10** (2023.01)
**H10N 50/85** (2023.01)

(21) Application number: **24167934.9**

(52) Cooperative Patent Classification (CPC):
**H10N 50/10; H10N 50/01; H10N 50/85**

(22) Date of filing: **29.03.2024**

(54) **SPIN ORBIT TORQUE MATERIALS AND MAGNETIC MEMORY DEVICE INCLUDING THE SAME**

SPIN-ORBIT-DREHMOMENTMATERIALIEN UND MAGNETISCHE SPEICHERVORRICHTUNG DAMIT

MATÉRIAUX DE COUPLE D'ORBITE DE SPIN ET DISPOSITIF DE MÉMOIRE MAGNÉTIQUE LES COMPRENANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **14.04.2023   KR 20230049586**
**07.02.2024   KR 20240019139**

(43) Date of publication of application:
**16.10.2024  Bulletin 2024/42**

(73) Proprietors:
• **Samsung Electronics Co., Ltd.**
**Suwon-si, Gyeonggi-do 16677 (KR)**
• **POSTECH Research and Business Development Foundation**
**Pohang-si, Gyeongsangbuk-do 37673 (KR)**

(72) Inventors:
• **CHO, Won Joon**
**16678 Suwon-si (KR)**
• **LEE, Daesu**
**37673 Pohang-si (KR)**
• **JO, Yongjoo**
**37673 Pohang-si (KR)**

(74) Representative: **Elkington and Fife LLP**
**Prospect House**
**8 Pembroke Road**
**Sevenoaks, Kent TN13 1XR (GB)**

(56) References cited:
**US-A1- 2019 006 581**

• **CHANG SEO HYOUNG ET AL: "Thickness-dependent structural phase transition of strained SrRuO3 ultrathin films: The role of octahedral tilt", PHYSICAL REVIEW B, vol. 84, no. 10, 1 September 2011 (2011-09-01), US, pages 104101 - 1, XP093191169, ISSN: 1098-0121, DOI: 10.1103/ PhysRevB.84.104101**
• **GU YOUDI ET AL: "An overview of SrRuO3-based heterostructures for spintronic and topological phenomena", JOURNAL OF PHYSICS D: APPLIED PHYSICS, INSTITUTE OF PHYSICS PUBLISHING, BRISTOL, GB, vol. 55, no. 23, 11 February 2022 (2022-02-11), XP020415796, ISSN: 0022-3727, [retrieved on 20220211], DOI: 10.1088/ 1361-6463/AC4FD3**
• **LIU LIANG ET AL: "Current-induced magnetization switching in all-oxide heterostructures", NATURE NANOTECHNOLOGY, NATURE PUB. GROUP, INC, LONDON, vol. 14, no. 10, 9 September 2019 (2019-09-09), pages 939 - 944, XP036898503, ISSN: 1748-3387, [retrieved on 20190909], DOI: 10.1038/S41565-019-0534-7**
• **LU JINGDI ET AL: "Electric field controllable high-spin SrRuO3 driven by a solid ionic junction", PHYSICAL REVIEW B, vol. 101, no. 21, 1 June 2020 (2020-06-01), pages 2144021 - 1, XP093191775, ISSN: 2469-9950, DOI: 10.1103/ PhysRevB.101.214401**

## Description

### FIELD OF THE INVENTION

The present disclosure relates to a spin orbit torque material and a manufacturing method of a spin orbit torque material.

### BACKGROUND OF THE INVENTION

A magneto resistive random-access memory (MRAM) is a non-volatile memory that exploits a tunnel magnetic resistance effect. The MRAM has merits compared to other memory devices in terms of speed, power consumption, and durability.

The MRAM may convert a magnetization direction of a free layer with a magnetic field caused by a current of a digit line. As the integration gradually increases, an interference phenomenon may occur where the information of adjacent cells is read together, and there is a drawback that the energy required for the direction conversion is high.

A spin transfer torque (STT) MRAM may change the magnetization direction of the free layer by directly flowing the current through the magnetic tunnel junction (MTJ), so it may compensate for the drawbacks of the conventional MRAM. However, the STT-MRAM is difficult to achieve an ultra-high speed and a low electric power due to structural and principle limitations. Accordingly, a spin orbit torque (SOT) MRAM is being developed.

### SUMMARY OF THE INVENTION

Some examples provide a method for manufacturing a spin orbit torque (SOT) material.

Some embodiments provide a spin orbit torque (SOT) material.

Some embodiments provide a magnetic memory device.

According to some examples, a method for manufacturing a spin orbit torque (SOT) material is provided. The method may include: generating plasma of particles of a target by, in a vacuum chamber, irradiating a surface of the target with a pulse laser; depositing a thin film on a substrate by reacting the plasma of particles and oxygen, of which a partial pressure of the oxygen is changed over time; and terminating the depositing the thin film based on the partial pressure of the oxygen reaching a final partial pressure.

In some examples, the depositing the thin film on the substrate may include changing the partial pressure of the oxygen based on a changing pattern of the partial pressure.

In some examples, the depositing the thin film on the substrate may include:
measuring a state of a surface of the thin film; and changing the partial pressure of the oxygen based on a measurement result of the state of the surface.

In some examples, the changing the partial pressure of the oxygen may include changing the partial pressure of the oxygen based on a reflection high energy electron diffraction (RHEED) intensity measured for the thin film.

In some examples, the changing the partial pressure of the oxygen based on the RHEED intensity may include changing the partial pressure to a first partial pressure smaller than an initial partial pressure of the oxygen based on the RHEED intensity being decreased after a peak of the RHEED intensity.

In some examples, the changing the partial pressure of the oxygen based on the RHEED intensity may include: depositing a sub-stack of the thin film according to the first partial pressure; monitoring that the RHEED intensity decreases again after a next peak based on a sub-stack of the thin film being deposited according to the first partial pressure; and changing the partial pressure to a second partial pressure smaller than the first partial pressure based on the RHEED intensity being decreased again after the next peak.

In some examples, the final partial pressure may be determined to be a value such that a perpendicular magnetic anisotropy appears at a top of the thin film.

According to some embodiments, a spin orbit torque (SOT) material is provided. The SOT material includes:
 : a substrate; and an epitaxial thin film including a plurality of sub-stacks on the substrate, wherein a crystal structure of a first sub-stack among the plurality of sub-stacks in a lower portion of the epitaxial thin film is an orthorhombic system and a crystal structure of a second sub-stack among the plurality of sub-stacks in an upper portion of the epitaxial thin film is a tetragonal system, and the lower portion of the epitaxial thin film is closer to the substrate than the upper portion of the epitaxial thin film.

In some embodiments, a lattice constant of the first sub-stack may be greater than a lattice constant of a third sub-stack adjacent to the first sub-stack, the third sub-stack being among the plurality of sub-stacks.

In some embodiments, a lattice constant of the lower portion of the epitaxial thin film may be smaller than a lattice constant of the upper portion of the epitaxial thin film.

In some embodiments, the epitaxial thin film may include a perovskite having an oxygen octahedral structure and a tilt angle of an oxygen octahedron of the first sub-stack may be greater than a tilt angle of an oxygen octahedron of the second sub-stack.

In some embodiments, the epitaxial thin film may include a perovskite having an oxygen octahedral structure and a tilt angle of an oxygen octahedron at the lower portion of the epitaxial thin film may be greater than a tilt angle of an oxygen octahedron at the upper portion of the epitaxial thin film.

In some embodiments, the epitaxial thin film may include a perovskite having an oxygen octahedral structure and a tilt angle of an oxygen octahedron at the lower portion of the epitaxial thin film may be 10° to 45° and a tilt angle of an oxygen octahedron at the upper portion of the epitaxial thin film may be 0°.

In some embodiments, the epitaxial thin film may include an $ABO_3$ crystal structure and a ratio A/B of an element A to an element B at the upper portion of the epitaxial thin film may be greater than a ratio A/B of the element A to the element B at the lower portion of the epitaxial thin film.

In some embodiments, the substrate may include a strontium titanium oxide ($SrTiO_3$) and the epitaxial thin film may include a strontium ruthenium oxide ($SrRuO_3$).

According to some embodiments, a spin orbit torque (SOT) material is provided. The SOT material may include: a substrate; and an epitaxial thin film including a plurality of sub-stacks on the substrate, wherein the epitaxial thin film includes an $ABO_3$ crystal structure, a proportion of an element B at an upper portion of the epitaxial thin film is smaller than a proportion of the element B at a lower portion of the epitaxial thin film, and the proportion of the element B in the epitaxial thin film decreases from a sub-stack at the lower portion to a sub-stack at the upper portion, wherein the sub-stack at the lower portion of the epitaxial thin film is closer to the substrate than the sub-stack at the upper portion of the epitaxial thin film.

According to some embodiments, a magnetic memory device is provided. The magnetic memory device may include: a spin orbit torque (SOT) material including a substrate and an epitaxial thin film on the substrate; a tunneling layer adjacent to the SOT material; and a pinned layer adjacent to the tunneling layer, wherein a crystal structure of a lower portion of the epitaxial thin film is an orthorhombic system, a crystal structure of an upper portion of the epitaxial thin film is a tetragonal system, and the lower portion of the epitaxial thin film is closer to the substrate than the upper portion of the epitaxial thin film.

In some embodiments, a lattice constant of the lower portion of the epitaxial thin film may be smaller than a lattice constant of the upper portion of the epitaxial thin film.

In some embodiments, the epitaxial thin film may include a perovskite having an oxygen octahedral structure and a tilt angle of an oxygen octahedron at the lower portion of the epitaxial thin film may be greater than a tilt angle of an oxygen octahedron at the upper portion of the epitaxial thin film.

In some embodiments, the epitaxial thin film may include a perovskite having an oxygen octahedral structure, a tilt angle of an oxygen octahedron at the lower portion of the epitaxial thin film may be 10° to 45°, and a tilt angle of an oxygen octahedron at the upper portion of the epitaxial thin film may be 0°.

In some embodiments, the epitaxial thin film may include an $ABO_3$ crystal structure and a ratio A/B of an element A to an element B at the upper portion of the epitaxial thin film may be greater than a ratio A/B of the element A to the element B at the lower portion of the epitaxial thin film.

In some embodiments, the substrate may include a strontium titanium oxide ($SrTiO_3$) and the epitaxial thin film may include a strontium ruthenium oxide ($SrRuO_3$).

In some embodiments, in response to supplying a pulse current to the SOT material, a tilted spin current may be generated in the SOT material, a magnetization switching in the SOT material may occur by the tilted spin current, and an alignment of magnetization vectors in the SOT material and the pinned layer may be changed based on the magnetization switching.

## BRIEF DESCRIPTION OF THE DRAWINGS

FIG. 1 is a diagram illustrating a magnetic memory device according to some embodiments.

FIG. 2 is a flowchart illustrating a manufacturing method of a SOT material according to some examples.

FIG. 3 is a graph illustrating a relationship between a surface measurement value of an epitaxial thin film and a partial pressure of oxygen of a PLD according to some embodiments.

FIG. 4 is a diagram illustrating a SOT material according to some embodiments.

FIG. 5 is a diagram illustrating an oxygen octahedron of an initial sub-stack according to some embodiments.

FIG. 6 is a diagram illustrating a change in a tilt of an oxygen octahedron in an epitaxial thin film according to some embodiments.

FIG. 7 is a graph illustrating a change in a lattice constant of a sub-stack in a SOT material according to some embodiments.

FIG. 8 is a diagram illustrating an atomic force microscope image of each sub-stack according to some embodiments.

FIG. 9 is a graph illustrating a hall resistance of a magnetic memory device according to a pulse current supplied to a SOT material according to some embodiments.

FIG. 10 is a diagram illustrating a SOT efficiency versus power consumption of a magnetic memory device according to some embodiments.

FIG. 11 is a block diagram of an electron system including a magnetic memory device according to embodiments.

FIG. 12 is a block diagram of an information processing system including a magnetic memory device according to embodiments.

FIG. 13 is a block diagram of a memory card including a magnetic memory device according to embodiments.

## DETAILED DESCRIPTION

In the following detailed description, some embodiments of the present invention and examples have been shown and described, simply by way of illustration. As those skilled in the art would realize, the described embodiments may be modified in various different ways, all without departing from the scope of the present invention. Accordingly, the drawings and description are to be regarded as illustrative in nature and not restrictive, and like reference numerals designate like elements throughout the specification.

In this specification, unless explicitly described to the contrary, the word "comprises", and variations such as "including" or "containing", will be understood to imply the inclusion of stated elements but not the exclusion of any other elements.

In this specification, expressions described in singular can be interpreted as singular or plural unless explicit expressions such as "one" or "single" are used.

As used herein, "A or B", "at least one of A and B", "at least one of A or B", "A, B, or C", "at least one of A, B, and C", and "at least one of A, B, or C" each may include any one of, or all possible combinations of, items listed together in the corresponding one of the phrases. For example, "at least one of A, B, and C," and similar language (e.g. "at least one selected from the group consisting of A,B, and C," " at least one of A,B, or C") may be construed as A only, B only, C only, or any combination of two or more of A, B, and C, such as, for instance, ABC, AB, BC, and AC.

In this specification, "and/or" includes all combinations of each and at least one of the mentioned elements.

In this specification, terms including ordinal numbers such as first and second may be used to describe various configurations elements, but the elements are not limited by the terms. The terms may be only used to distinguish one element from another element. For example, a first element may be named a second element without departing from the right range of the present inventive concepts, and similarly, a second element may be named a first element.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

In a flowchart described with reference to drawings in this specification, the order of operations may be changed, several operations may be merged, some operations may be divided, and specific operations may not be performed.

When the terms "about" or "substantially" are used in this specification in connection with a numerical value, it is intended that the associated numerical value includes a manufacturing or operational tolerance (e.g., $\pm 10\%$) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., $\pm 10\%$) around the stated numerical values or shapes. When ranges are specified, the range includes all values therebetween such as increments of 0.1%.

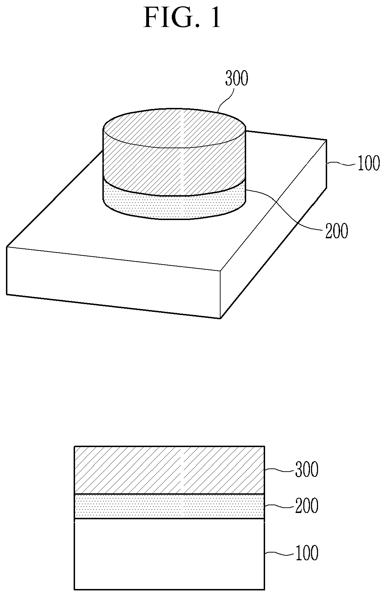

FIG. 1 is a diagram illustrating a magnetic memory device according to some embodiments.

Referring to FIG. 1, a magnetic memory device according to some embodiments may include a spin orbit torque (SOT) material 100, a tunneling layer 200 disposed adjacent to the SOT material 100, and a pinned layer 300 disposed adjacent to the tunneling layer 200. In some embodiments, the magnetic memory device may be a magnetoresistive random-access memory (MRAM). While FIG. 1 illustrates the SOT material 100, tunneling layer 200, and pinned layer 300 as planar films stacked on each other, embodiments are not limited thereto. For example, the magnetic memory device may be embodied in different forms (e.g., a cylindrical SOT material 100 surrounded by a cylindrical pinned layer 300 and a cylindrical tunneling layer 200 therebetween).

The thickness of the tunneling layer 200 disposed adjacent to the SOT material 100 may be thinner than the spin diffusion length. Accordingly, the tunneling layer 200 may be thin enough to cause a tunneling effect.

The tunneling layer 200 may include a non-magnetic material. According to some embodiments, the tunneling layer 200 may include at least one of magnesium (Mg), titanium (Ti), aluminum (Al), oxide of magnesium-zinc (MgZn) and magnesium-boron (MgB), and nitride of titanium (Ti) and vanadium (V). In some embodiments, the tunneling layer 200 may be an oxidation magnesium (MgO) film. The tunneling layer 200 may include a multiple layer. For example, the tunneling layer 200 may include a multiple layer in which magnesium (Mg) and oxidation magnesium (MgO) are alternately stacked. The tunneling layer 200 may have a pre-determined crystal structure. For example, the tunneling layer 200 may have a face centered cubic lattice structure such as a crystal structure of the NaCl.

The pinned layer 300 may be disposed on top of the tunneling layer 200. The magnetization of the pinned layer 300 may be fixed. As a magnetization switching occurs in the SOT material 100, the magnetization vectors in the pinned layer 300 may be parallel or antiparallel to the magnetization vectors of the SOT material 100.

When the magnetization vectors of the SOT material 100 and the pinned layer 300 are parallel, resistance of the magnetic memory device may be measured relatively small due to the large tunneling effect generated in the tunneling layer 200 disposed between the SOT material 100 and the pinned layer 300. When the magnetization vectors of the SOT material 100 and the pinned layer 300 are antiparallel, the resistance of the magnetic memory device may be measured relatively large due to the small tunneling effect that occurs in the tunneling layer 200 disposed between the SOT material 100 and the pinned layer 300. The variation of the resistance of the magnetic memory device depending on the direction of the magnetization vectors in the SOT material 100 and the pinned layer 300 is due to spin polarization of a ferromagnetic body of the SOT material 100 and the pinned layer 300 and the tunneling effect of electrons passing through the tunneling layer 200. The relatively small resistance and large resistance of the magnetic memory device may correspond to logic 0 and 1, respectively.

The pinned layer 300 may include ferromagnetic materials such as Fe, Co, Ni or alloys thereof and multi-layer structures thereof. The pinned layer 300 may further include B, Cr, Pt, Pd, and the like. For example, the pinned layer 300 may include NiFe, CoFe, NiFeB, CoFeB, NiFeSiB, or CoFeSiB.

When the magnetic memory device performs a write operation of data, a tilted spin current may be generated in the SOT material 100 by a spin-hall effect caused by a charge current supplied through the SOT material 100 and a net magnetization vector of the SOT material 100 may be switched. The state of the switched magnetization vector may correspond to recording of the data.

When the magnetic memory device performs a read operation of the written data, resistance of the magnetic memory device may be measured by a resistance measuring device. The resistance measurement may be performed by sending a small sensing current to the magnetic memory device to produce a sensing voltage. A value corresponding to the measured resistance may be output as a result of the read operation. In general, when the magnetization vector of the SOT material 100 and the magnetization vector of the pinned layer 300 are aligned in parallel, the resistance of the magnetic memory device can be measured as a relatively small value.

The SOT material 100 according to some embodiments includes an epitaxial thin film of topological materials epitaxially growth on a substrate by using a pulsed laser deposition (PLD) device.

Each of the substrate and the epitaxial thin film deposited on the substrate may include a perovskite having an $ABO_3$ crystal structure. In Chemical Formula $ABO_3$ of the perovskite, 'A' of the formula may be a metal positive ion such as an alkaline-earth metal positive ion (e.g., $Sr^{2+}$ or $Ba^{2+}$) and 'B' of the formula may be a transition element positive ion. The crystal structure of the perovskite may be a $BO_6$ octahedron having shared corners in a three-dimensional arrangement. The oxygen octahedrons may share the 'A' positive ions with each other (that is, the junctions between the oxygen octahedrons may be occupied by the 'A' positive ions). In the perovskite in these concepts, components of the $BO_6$ octahedron may have an oxygen octahedral connectivity that is tilted to an ideal tetragonal structure.

A transition metal oxide is free from oxidation problems that may inevitably occur in the process of a downsizing/integration of devices, and the composite oxide has a merit of being able to have various new quantum states due to the interaction between multiple freedom degrees (lattice, charge, spin, and orbital). In addition, through the $ABO_3$ perovskite oxide, various physical properties/functionalities that do not exist in nature have already been realized. In addition, in the transition metal oxides, since the ferromagnetic and the spin hall effect may be originated from transition metal atoms, the transition metal oxides may be easy to be used for targeted single-phase/single-element materials.

The oxygen octahedral tilt of the perovskite of the present invention may be the result of a lattice mismatch between the substrate and the perovskite (e.g., the epitaxial thin film) deposited on the substrate. That is, when the epitaxial thin film is grown on the substrate of which the formation is different from the epitaxial thin film, a compressive strain or a tensile strain may be induced in a part of the epitaxial thin film in contact with the substrate, and accordingly, the $BO_6$ octahedron of the perovskite may be tilted. In the present invention, when the oxygen octahedral tilt is generated at a portion in contact with the substrate in the epitaxial thin film and no oxygen octahedral tilt is generated at a portion far from the substrate, a tilted spin current is induced in the epitaxial thin film and a magnetization switching may occur in the SOT material due to the tilted spin current.

In some embodiments, the substrate may be strontium titanium oxide ($SrTiO_3$) and the thin film may be strontium ruthenium oxide ($SrRuO_3$). As a material including 4d transition metals, the strontium ruthenium oxide may have ferromagnetic, metallic, and the spin hall effect, simultaneously. This characteristic of the strontium ruthenium oxide may be attributed to the Ru atom orbital. Since the strontium ruthenium oxide has a large spin Hall effect and an intrinsic spin Hall effect due to an intrinsic Berry curvature, it may be freed from the problem that the spin current due to the spin Hall effect may be out of a phase due to ferromagnetic magnetization.

In some embodiments, the substrate and/or the thin film may be one of $DyScO_3$, $GdScO_3$, $NdScO_3$, LSAT ($[LaAlO_3]0.3[Sr_2AlTaO_6]0.7$), $LaAlO_3$, or $NdGaO_3$. However, the embodiments are not limited thereto.

In some embodiments, the epitaxial thin film may have the same crystal structure and orientations as the substrate. Atoms in the epitaxial thin film may be arranged in a structure similar to a lattice that is maintained over relatively long distances on an atomic scale. In these inventive concepts, "epitaxial" may be used to describe a predominantly large crystalline structure with an acceptable number of defects inside.

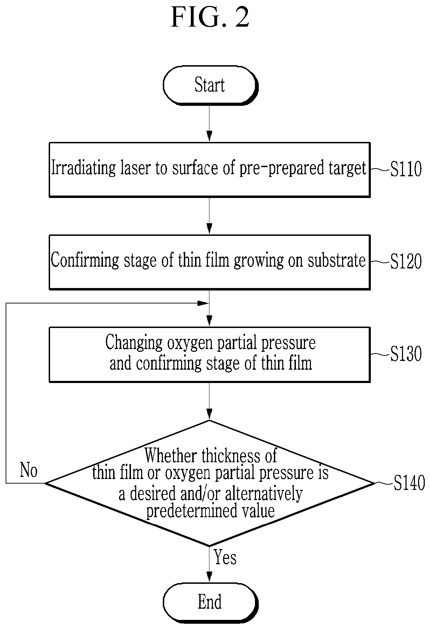

FIG. 2 is a flowchart illustrating a manufacturing method of a SOT material according to some examples.

Referring to FIG. 2, to grow the epitaxial thin film on the substrate, a PLD device may irradiate a high energy pulse laser to a surface of a previously prepared target in a vacuum chamber including an oxygen atmosphere (S110). The pulse laser may be irradiated at an interval of several Hz to several tens of Hz. When the pulse laser reaches the surface of the target, the laser and materials of the target may be reacted and the surface of the target may be separated (an ablation), and particles separated from the target may form plasma (a plume). In some embodiments, the plume detached from the target and formed on the periphery of the surface of the target may be deposited on a substrate positioned opposite the target while freely expanding in an adiabatic vacuum environment. The plume may react with surrounding oxygen molecules to form an oxide crystal structure on the substrate. The oxide crystal formed of a thin film on the substrate may have the same composition (stoichiometry) as that of the target.

In a manufacturing method of the SOT material according to some embodiments, the state of the thin film grown on the substrate is confirmed (S120). In some embodiments, when it is confirmed that the thin film is grown flat and evenly, a partial pressure of the oxygen may be changed (S130). For example, the partial pressure of the oxygen around the plume may be controlled according to the state of the thin film deposited on the substrate. While the partial pressure of oxygen is controlled, the pulse laser irradiation may be temporarily stopped.

Since the spin current by the spin Hall effect causes the accumulation of spins of the same size at both interfaces of the SOT material, a magnetization switching by the charge current may be difficult to show a net effect within a single SOT material. The manufacturing method of the SOT material according to some embodiments may induce a symmetrical gradient of the ferromagnetic (e.g., the direction of the magnetization) and a rotation pattern of the oxygen octahedron by controlling the partial pressure of oxygen during the deposition of the thin film. That is, asymmetry of the spin accumulation is induced at both interfaces of the SOT material by the symmetrical gradient induced in the SOT material, and the net SOT effect may occur thereby. For example, the strontium ruthenium oxide may have tilted magnetization when deposited at a high partial pressure of oxygen and may have a substantially perfect perpendicular magnetic anisotropy characteristic when deposited at a low partial pressure of oxygen. Therefore, the single phase/single source free field SOT magnetization switching may be implemented in the single thin film material of the strontium ruthenium oxide with the artificially induced symmetry gradient, and in this case, a magnetic memory device may be driven with higher efficiency and/or lower electric power.

In the manufacturing method of the SOT material according to some embodiments, the partial pressure of oxygen in the vacuum chamber of the PLD device may be increased or decreased during the deposition of the epitaxial thin film. The rate of increasing and decreasing of the partial pressure of oxygen may be pre-determined. For example, an initial partial pressure of oxygen may be $100 \cdot 10^{-3}$ Torr and then the partial pressure of oxygen may be lowered by $5 \cdot 10^{-3}$ Torr or $10 \cdot 10^{-3}$ Torr depending on the state of the thin film. Alternatively, the partial pressure of oxygen may decrease from the initial partial pressure of oxygen and then increase again from a specific point in time. The final partial pressure of oxygen may be determined according to the thickness of the thin film or may be a pre-determined value.

In some examples, the flat and even growth of the thin film may be determined using an analysis device for the surface of the thin film. For example, the analysis device for the surface of the thin film may be a reflection high-energy electron diffraction (RHEED) device. The RHEED device may measure a microstructure of the thin film using an electron beam with high energy. The RHEED device may emit a high energy electron beam onto the surface of the substrate at a relatively large incidence angle (e.g., the electron beam may be irradiated at an angle of 95-99 degrees to a normal of the substrate surface) and may measure an intensity and/or pattern of the electron beam diffracted by crystal lattices of the thin film on the surface. In the manufacturing method of the SOT material according to some examples, the partial pressure of oxygen may be determined based on the measured value of the surface state determined by the RHEED device.

In some embodiments, the number of pulse lasers required to generate the plasma may be precisely controlled whenever the partial pressure of oxygen is changed using the RHEED device.

The pulse laser may irradiate the target again in the changed partial pressure of oxygen environment, and the plume generated accordingly may be deposited again on the already deposited epitaxial thin film. The epitaxial thin film may be continuously deposited until the thickness of the thin film reaches the pre-determined value and/or the partial pressure of oxygen decreases to the desired and/or alternatively predetermined value (S140).

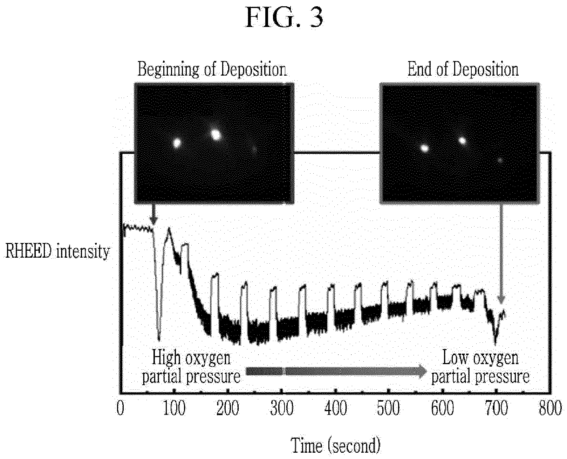

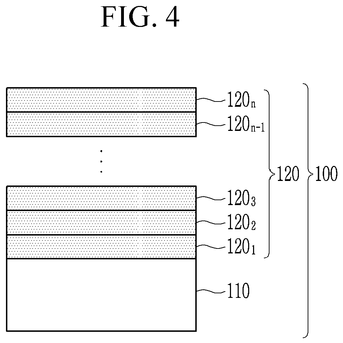

FIG. 3 is a graph illustrating a relationship between measurement value of a surface of an epitaxial thin film and a partial pressure of oxygen of a PLD according to some embodiments. FIG. 4 is a diagram illustrating a SOT material according to some embodiments.

Referring to FIG. 3, the state of the surface of the epitaxial thin film grown on the substrate may be determined by the RHEED intensity (a relative value), and the partial pressure of oxygen in the PLD device may be changed when the RHEED intensity is reduced. The PLD device according to some embodiments may adjust the partial pressure of oxygen when the RHEED intensity decreases after the peak of the RHEED intensity appears. For example, the PLD device may change the partial pressure of oxygen in the vacuum chamber from an initial partial pressure of oxygen of $80 \cdot 10^{-3}$ Torr to $75 \cdot 10^{-3}$ Torr or $70 \cdot 10^{-3}$ Torr.

When the epitaxial thin film begins to grow again at the reduced partial pressure of oxygen, the PLD device may monitor that the RHEED intensity represents the peaking again and then decreases. The PLD device may adjust the partial pressure of oxygen to another partial pressure when the RHEED intensity decreases again from the next peak. For example, the PLD device may lower the partial pressure from the modified partial pressure of oxygen of $70 \cdot 10^{-3}$ Torr to $60 \cdot 10^{-3}$ Torr.

In some embodiments, an optimized changing pattern of the partial pressure of the oxygen may be determined based on the analysis results for the surface of the thin film deposited on the substrate by an analysis device. For example, the PLD device may deposit the thin film on the substrate while changing the partial pressure of the oxygen according to the desired and/or alternatively predetermined changing pattern of the partial pressure of the oxygen. When the PLD device changes the partial pressure of oxygen according to the desired and/or alternatively predetermined changing pattern of the partial pressure of oxygen and deposits the thin film on the substrate, the PLD device may check the state of the thin film after the partial pressure of oxygen changed according to the changing pattern.

In some embodiments, the PLD device may terminate the deposition of the epitaxial thin film when the partial pressure of oxygen reaches the final partial pressure of oxygen. Alternatively, the PLD device may terminate the deposition of the epitaxial thin film when the partial pressure of oxygen reaches a desired and/or alternatively predetermined ratio to the initial partial pressure of oxygen (e.g., $1/r$ ($r$ is a real number) of the initial partial pressure of oxygen). The final partial pressure of oxygen may be desired and/or alternatively pre-determined by experiment and may be predetermined as a value that allows perpendicular magnetic anisotropy to appear at the upper portion of the epitaxial thin film. For example, the final partial pressure of oxygen may be a value such that a perpendicular magnetic anisotropy appears at a top of the epitaxial thin film.

The images on the graph in FIG. 3 show the RHEED image at the beginning of the deposition of the epitaxial thin film and the RHEED image at the end of the deposition, respectively. The RHEED image at the beginning of the deposition of the epitaxial thin film may show the part of the epitaxial thin film relatively close to the substrate (the lower portion of the epitaxial thin film). The RHEED image at the end of the deposition of the epitaxial thin film may show the part of the epitaxial thin film that is relatively far from the substrate (the upper portion of the epitaxial thin film).

In the SOT material according to some embodiments, physical and chemical characteristics of the lower and upper portions of the epitaxial thin film 120 may be different so that functions of a spin Hall layer and a free layer can be performed simultaneously in the same SOT material.

In some embodiments, the lower portion of the epitaxial thin film 120 and the upper portion of the epitaxial thin film 120 may be different from each other in terms of a stoichiometric amount. For example, the upper portion of the epitaxial thin film deposited at a low partial pressure of oxygen may have a lower ratio of the transition metal than the lower portion of the epitaxial thin film deposited at a high partial pressure of oxygen. The proportion of the transition metal positive ion in the epitaxial thin film may gradually decrease from the lower portion of the epitaxial thin film to the upper portion of the epitaxial thin film.

The oxygen octahedron at the lower portion of the epitaxial thin film may be tilted and the oxygen octahedron at the upper portion of the epitaxial thin film may stand relatively upright. Since the oxygen octahedron at the lower portion of the epitaxial thin film is tilted and the oxygen octahedron at the upper portion of the epitaxial thin film stands relatively upright, a lattice constant at the lower portion of the epitaxial thin film may be smaller than a lattice constant at the upper portion of the epitaxial thin film. In some embodiments, the lattice constant in the epitaxial thin film may increase from the lower portion of the epitaxial thin film to the upper portion of the epitaxial thin film.

In some embodiments, a difference in the tilt angle of the oxygen octahedron in the epitaxial thin film 120 may form a symmetric gradient of ferromagnetic (e.g., an easy axis direction of the magnetization) inside the epitaxial thin film 120 and the symmetric gradient of the epitaxial thin film 120 may generate the tilted spin current, so the magnetization switching of the SOT material may be induced (e.g., the net SOT effect due to the spin Hall effect). Since a free field switching successfully occurs in the SOT material according to some embodiments, the functions of the spin Hall layer and the free layer of the conventional magnetic memory device may be simultaneously performed by the SOT material of a single material.

Referring to FIG. 4, the SOT material 100 according to some embodiments may include a substrate 110 and an epitaxial thin film 120 epitaxially grown on the substrate 110. Whenever the partial pressure of oxygen is changed, a sub-stack may grow on the substrate, and accordingly, the epitaxial thin film 120 may include a plurality of sub-stacks $120_1$ to $120_n$.

Each sub-stack included in the epitaxial thin film 120 may be grown at different partial pressures of oxygen. For example, the first sub-stack $120_1$ directly above the substrate may be grown at the partial pressure of oxygen of $80 \cdot 10^{-3}$ Torr, the second sub-stack $120_2$ may be grown at the partial pressure of oxygen of $75 \cdot 10^{-3}$ Torr, and the final sub-stack ($120_n$, the final sub-stack of the epitaxial thin film) may be grown at the partial pressure of oxygen of $20 \cdot 10^{-3}$ Torr. The thickness of each sub-stack may be equal to the thickness of one unit crystal (unit cell, uc), and the thickness of the epitaxial thin film may be less than 10 nm. In FIG. 4, n may be an integer 50 or less (e.g., less than 50, 25 or less), but is not limited thereto.

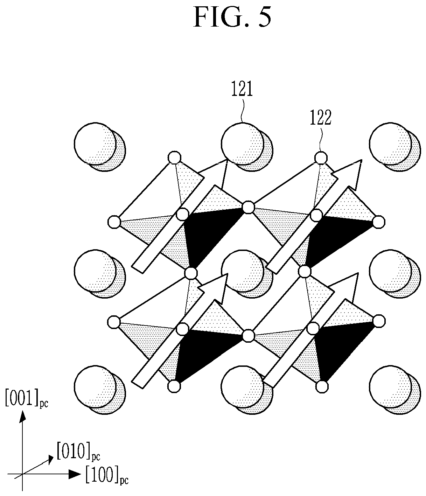

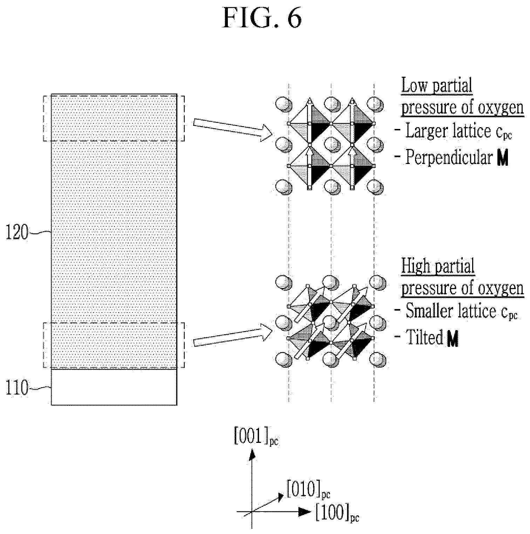

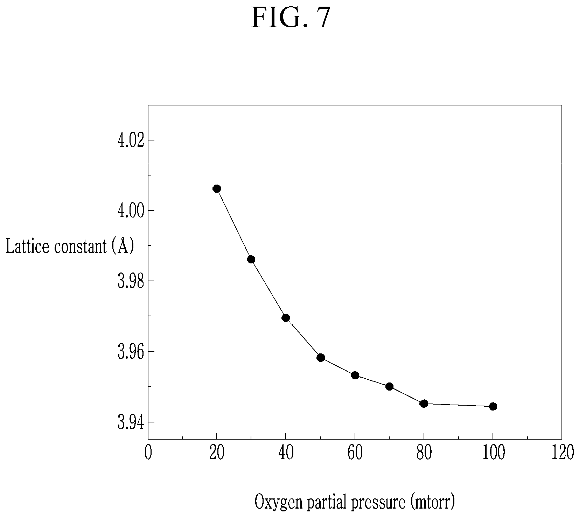

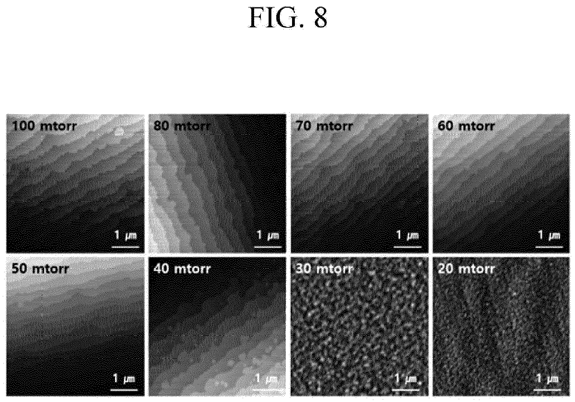

FIG. 5 is a diagram illustrating an oxygen octahedron of an initial sub-stack according to some embodiments. FIG. 6 is a diagram illustrating a change in a tilt angle of an oxygen octahedron in an epitaxial thin film according to some embodiments. FIG. 7 is a graph illustrating a change in a lattice constant of a sub-stack in an SOT material according to some embodiments. FIG. 8 is a diagram illustrating an atomic force microscope image of each sub-stack according to some embodiments.

Referring to FIG. 5, an oxygen octahedron of an initial sub-stack at a lower portion of an epitaxial thin film 120 is shown. In some embodiments, when a sub-stack of the epitaxial thin film 120 is grown at the relatively high partial pressure of oxygen, the crystal structure of the sub-stack may become an orthorhombic system. Then, the tilt angle of the oxygen octahedron may be 10 to 45 degrees.

In some embodiments, in the sub-stack grown at the relatively high partial pressure of oxygen, a transition metal (e.g., Ru) with relatively less reactivity than an alkaline-earth metal (e.g., Sr) may react more with the oxygen, thereby the relatively large amount of the transition metal may be in the sub-stack. Then, the sub-stack at the lower portion of the epitaxial thin film grown at the relatively high partial pressure of oxygen may have a relatively low Sr stoichiometry (Sr/Ru) (e.g., about 1).

Sub-stack may grow at the partial pressure of oxygen that is gradually lowered, and the crystal structure of the sub-stack at the upper portion of the epitaxial thin film 120 may change into a tetragonal system. That is, the tilt angle of the oxygen octahedron may be reduced from 10°- 45° to substantially 0° as the partial pressure of oxygen decreases. This portion of the thin film (e.g., the upper portion of the epitaxial thin film) may exhibit a perpendicular magnetic anisotropy, for example perfect perpendicular magnetic anisotropy.

In some embodiments, in the sub-stack grown at a relatively low partial pressure of oxygen, the transition metal (Ru), which has the relatively less reactivity than the alkaline-earth metal (Sr), reacts less with the oxygen, so the amount of the transition metal within the sub-stack may be relatively reduced. Therefore, the sub-stack at the upper portion of the epitaxial thin film grown at a relatively low partial pressure of oxygen may have a relatively high Sr stoichiometry (Sr/Ru) (e.g., about 1.2).

Referring to FIG. 6 and FIG. 7, the crystal structure of the sub-stack grown at a relatively high partial pressure of oxygen may have a tilted oxygen octahedron and have a relatively small lattice constant. On the other hand, the crystal structure of the sub-stack grown at a relatively low partial pressure of oxygen may show the upright oxygen octahedron and have the relatively large lattice constant. The lattice constant of each sub-stack may be determined by an X-ray experiments such as an X-ray diffractometer or a reciprocal space mapping.

In the sub-stack grown at a relatively high partial pressure of oxygen, the distance between the transition metal 121 and the oxygen 122 (a lattice constant) may be relatively short due to the tilted oxygen octahedron. On the other hand, the distance between the transition metal 121 and the oxygen 122 may be relatively long due to the non-tilted oxygen octahedron.

Referring to FIG. 7, the lattice constant of the sub-stack formed at a relatively high partial pressure of oxygen ($80 \cdot 10^{-3}$ Torr and $100 \cdot 10^{-3}$ Torr) is slightly larger than 3.94Å, but as the partial pressure of oxygen decreases and the lattice constant of the sub-stack continues to increase, the lattice constant of the sub-stack formed at a relatively low partial pressure of oxygen ($20 \cdot 10^{-3}$ Torr) may be greater than 4.00 Å.

FIG. 8 is a diagram illustrating atomic force microscope (AFM) images of different sub-stacks of the epitaxial thin film 120 grown at each partial pressure of oxygen. Referring to FIG. 8, It may be confirmed that the epitaxial thin film 120 is synthesized with high quality even under different conditions of partial pressure of oxygen.

The functions of the spin Hall layer and the free layer of the magnetic memory device may be performed simultaneously by the epitaxial thin film having the tilt angle difference of the oxygen octahedron inside. In addition, the SOT material according to some embodiments may achieve high SOT efficiency and consume less electric power.

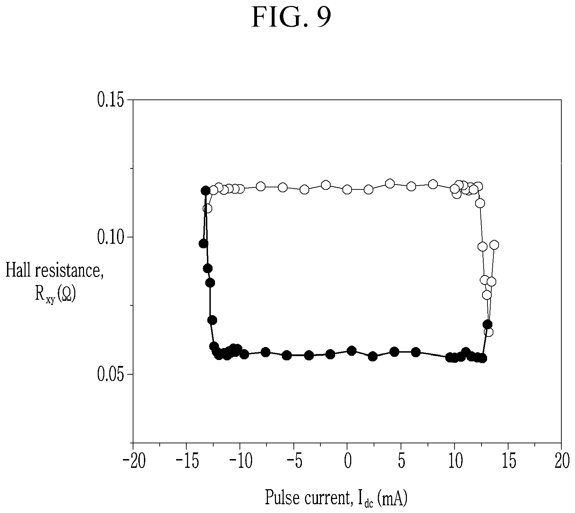

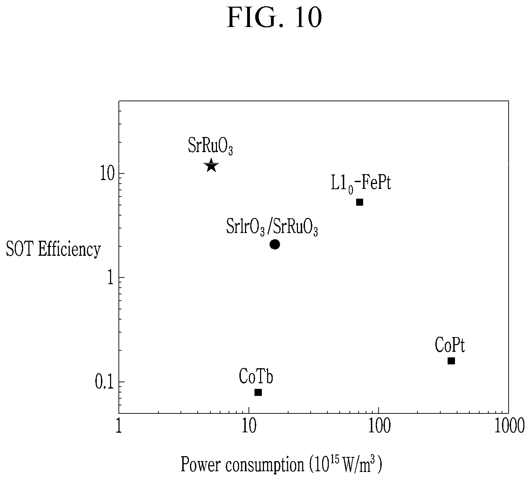

FIG. 9 is a graph illustrating a Hall resistance of SOT material according to a pulse current provided to a SOT material according to some embodiments. FIG. 10 is a diagram illustrating a SOT efficiency versus power consumption of a SOT material according to some embodiments.

When a pulse current is provided to a SOT material having a symmetrical gradient according to some embodiments, a Hall resistance of the SOT material may be switched based on magnitude of the pulse current. When the magnitude of the pulse current provided to the SOT material increases from a negative value to a positive value, the Hall resistance of the SOT material may be switched from a relatively large value to a relatively small value. Alternatively, when the magnitude of the pulse current supplied to the SOT material decreases from a positive value to a negative value, the Hall resistance of the SOT material may be switched from a relatively small value to a relatively large value. Then, the absolute value of the current at which the switching of the Hall resistance occurs may be referred to as a critical switching current.

When the critical switching current is provided to the SOT material according to some embodiments without an external magnetic field, magnetization switching may occur due to a change in the Hall resistance and data write operation of the magnetic memory device may be implemented by the magnetization switching.

Referring to FIG. 9, when the Hall resistance is greater than 0.10 Ω, if the pulse current gradually increases from a negative value and reaches about 13 mA, the Hall resistance may decrease sharply to switch to about 0.06 Ω (empty dot line). In other words, while the pulse current increases by about 2 mA from 12 mA to 14 mA, the magnitude of the Hall resistance may decrease by about half from about 0.13 Ω to about 0.06 Ω.

When the Hall resistance is smaller than 0.07 Ω, if the pulse current gradually decreases from a positive value to about -13 mA, the Hall resistance may increase sharply to switch to about 0.13 Ω (filled dot line). In other words, while the pulse current decreases by about 2 mA from -12 mA to -14 mA, the magnitude of the Hall resistance may approximately double from about 0.06 Ω to about 0.13 Ω. In FIG. 9, the critical switching current of the SOT material may be determined to be 13 mA.

Referring to FIG. 10, it may be confirmed that the SOT efficiency and power consumption of the SOT material ($SrRuO_3$) according to some embodiments is superbly better than other materials. The SOT material according to some embodiments may achieve SOT efficiency exceeding 10 (15.35) with low power consumption ($5.15 \times 10^{15}$ W/m$^3$). The SOT efficiency and the power consumption of the SOT material according to some embodiments may be calculated by Equations 1 and 2 below, respectively.

(Equation 1)

$$\text{SOT efficiency} = \frac{4e}{\pi\hbar} M_s t \frac{H_c}{J_{sc}}$$

In Equation 1, e is a basic charge, $\pi$ is a circumferential rate, $\hbar$ is the reduced Planck constant, $M_s$ is saturation magnetization, t is a thickness of a $SrRuO_3$ thin film, $H_c$ is a coercive field, and $J_{sc}$ is a critical switching current density.

(Equation 2)

$$\text{Power Consumption } (P_{sw}) = J_{sc}^2 \times \rho$$

In Equation 2, $J_{sc}$ means a critical switching current density, $\rho$ means a resistivity of $SrRuO_3$ layer.

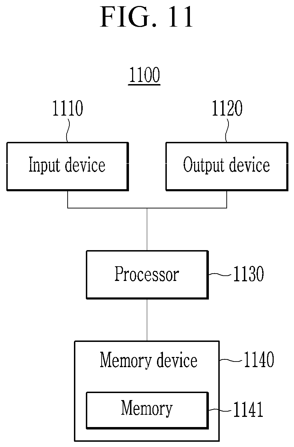

As described above, the large spin hall angle and small electrical resistance of the SOT materials make it possible to use a small critical switching current to reduce the power density of magnetic memory devices. Furthermore, the low critical switching current and low power density enable ultra-high speed and low power consumption of the magnetic memory device. The magnetic memory device according to some embodiments may be utilized in a next-generation spin memory device, such as a spin logic device, a spin transistor, and the like. Furthermore, the magnetic memory device according to some embodiments may implement topologically stable qubits, which can be utilized in quantum computers. FIG. 11 is a block diagram of an electron system including a magnetic memory device according to some embodiments.

Referring to FIG. 11, an electron system 1100 may include an input device 1110, an output device 1120, a processor 1130, and a memory device 1140. In some examples, the memory device 1140 may include a cell array including non-volatile memory cells and a peripheral circuit for read/write operations. In some other examples, the memory device 1140 may include a non-volatile memory device and a memory controller.

The memory 1141 included in the memory device 1140, referring to FIG. 1 to FIG. 10, according to the example described, may include the SOT material or the magnetic memory device including the SOT material.

The processor 1130 is respectively connected to the input device 1110, the output device 1120, and the memory device 1140 through an interface to control the overall operation.

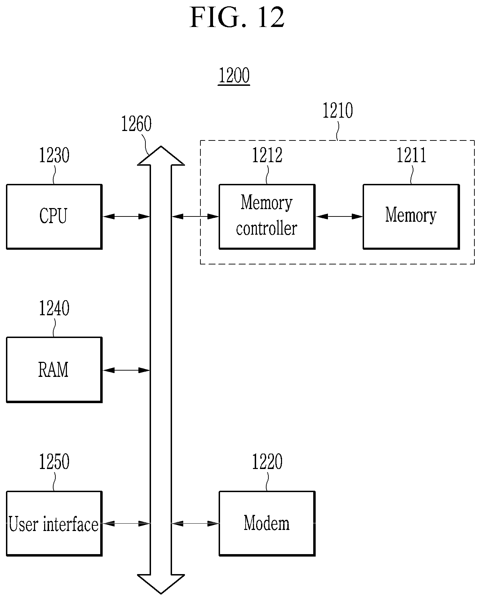

FIG. 12 is a block diagram of an information processing system including a magnetic memory device according to some embodiments.

Referring to FIG. 12, an information processing system 1200 may include a non-volatile memory system 1210, a modem 1220, a central processing device (CPU) 1230, a RAM 1240 and a user interface 1250, which are electrically connected to a bus 1260.

The non-volatile memory system 1210 may include a memory 1211 and a memory controller 1212. The non-volatile memory system 1210 may store a data processed by the central processing device 1230 or a data input from the outside.

The non-volatile memory system 1210 may include a non-volatile memory such as MRAM, PRAM, RRAM, and FRAM. At least one of the memories 1211 and the RAM 1240, referring to FIG. 1 to FIG. 10, according to the above-described embodiments, may include the SOT material or the magnetic memory device including the SOT material.

The information processing system 1200 may be used in a portable computer, a web tablet, a wireless phone, a mobile phone, a digital music player, a memory card, an MP3 player, a navigation, a portable multimedia player (PMP), a solid-state disk (SSD) or a household appliance.

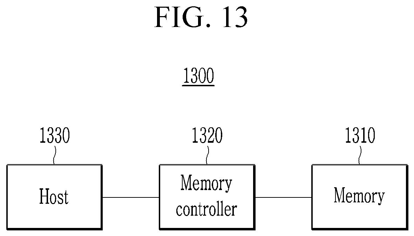

FIG. 13 is a block diagram of a memory card including a magnetic memory device according to some embodiments.

The memory card 1300 may include a memory 1310 and a memory controller 1320.

The memory 1310 may store a data. In some examples, the memory 1310 has a non-volatile characteristic that may retain a stored data even if the power supply is interrupted. The memory 1310, referring to FIG. 1 to FIG. 10, according to the described embodiments, may include the SOT material or the magnetic memory device including the SOT material.

The memory controller 1320 may read the data stored in the memory 1310 or store the data in the memory 1310 in response to a read/write request from the host 1330.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A spin orbit torque, SOT, material (100) comprising:

   a substrate (110); and
   an epitaxial thin film (120) including a plurality of sub-stacks ($120_n$) on the substrate,
   **characterized in that** a crystal structure of a first sub-stack ($120_1$) among the plurality of sub-stacks in a lower portion of the epitaxial thin film is an orthorhombic system and a crystal structure of a second sub-stack among the plurality of sub-stacks in an upper portion of the epitaxial thin film is a tetragonal system, and
   the lower portion of the epitaxial thin film is closer to the substrate than the upper portion of the epitaxial thin film.

2. The SOT material of claim 1, wherein
   a lattice constant of the first sub-stack is greater than a lattice constant of a third sub-stack adjacent to the first sub-stack, the third sub-stack being among the plurality of sub-stacks.

3. The SOT material of claim 1 or 2, wherein a lattice constant of the lower portion of the epitaxial thin film is smaller than a lattice constant of the upper portion of the epitaxial thin film.

4. The SOT material of any preceding claim, wherein
   the epitaxial thin film includes a perovskite having an oxygen octahedral structure and a tilt angle of an oxygen octahedron of the first sub-stack is greater than a tilt angle of an oxygen octahedron of the second sub-stack.

5. The SOT material of any preceding claim, wherein
   the epitaxial thin film includes a perovskite having an oxygen octahedral structure and a tilt angle of an oxygen octahedron at the lower portion of the epitaxial thin film is greater than a tilt angle of an oxygen octahedron at the upper portion of the epitaxial thin film.

6. The SOT material of claim 5, wherein
   the epitaxial thin film includes a perovskite having an oxygen octahedral structure and a tilt angle of an oxygen octahedron at the lower portion of the epitaxial thin film is 10° to 45° and a tilt angle of an oxygen octahedron at the upper portion of the epitaxial thin film is 0°.

7. The SOT material of any preceding claim, wherein
the epitaxial thin film includes an $ABO_3$ crystal structure and a ratio of an element B to an element A at the upper portion of the epitaxial thin film is greater than a ratio of the element B to the element A at the lower portion of the epitaxial thin film.

8. The SOT material of any preceding claim, wherein the substrate includes a strontium titanium oxide, $SrTiO_3$, and the epitaxial thin film includes a strontium ruthenium oxide, $SrRuO_3$.

9. A magnetic memory device comprising:

   a spin orbit torque, SOT, material (100) according to any preceding claim;
   a tunneling layer (200) adjacent to the SOT material; and
   a pinned layer (300) adjacent to the tunneling layer.

10. The magnetic memory device of claim 9, wherein in response to supplying a pulse current to the SOT material, a tilted spin current is generated in the SOT material, a magnetization switching in the SOT material occurs by the tilted spin current, and an alignment of magnetization vectors in the SOT material and the pinned layer is changed based on the magnetization switching.

**Patentansprüche**

1. Spin-Orbit-Drehmomentmaterial, SOT-Material, (100), umfassend:

   ein Substrat (110); und
   einen epitaktischen Dünnfilm (120), der eine Vielzahl von Teilstapeln ($120_n$) enthält, auf dem Substrat,
   **dadurch gekennzeichnet, dass** eine Kristallstruktur eines ersten Teilstapels ($120_1$) aus der Vielzahl von Teilstapeln in einem unteren Abschnitt des epitaktischen Dünnfilms ein orthorhombisches System ist und eine Kristallstruktur eines zweiten Teilstapels aus der Vielzahl von Teilstapeln in einem oberen Abschnitt des epitaktischen Dünnfilms ein tetragonales System ist und
   der untere Abschnitt des epitaktischen Dünnfilms näher an dem Substrat ist als der obere Abschnitt des epitaktischen Dünnfilms.

2. SOT-Material nach Anspruch 1, wobei
eine Gitterkonstante des ersten Teilstapels größer als eine Gitterkonstante eines dritten Teilstapels benachbart zu dem ersten Teilstapel ist, wobei der dritte Teilstapel aus der Vielzahl von Teilstapeln ist.

3. SOT-Material nach Anspruch 1 oder 2, wobei eine Gitterkonstante des unteren Abschnitts des epitaktischen Dünnfilms kleiner als eine Gitterkonstante des oberen Abschnitts des epitaktischen Dünnfilms ist.

4. SOT-Material nach einem vorhergehenden Anspruch, wobei
der epitaktische Dünnfilm einen Perowskit mit einer Sauerstoffoktaederstruktur enthält und ein Neigungswinkel eines Sauerstoffoktaeders des ersten Teilstapels größer als ein Neigungswinkel eines Sauerstoffoktaeders des zweiten Teilstapels ist.

5. SOT-Material nach einem vorhergehenden Anspruch, wobei
der epitaktische Dünnfilm einen Perowskit mit einer Sauerstoffoktaederstruktur enthält und ein Neigungswinkel eines Sauerstoffoktaeders an dem unteren Abschnitt des epitaktischen Dünnfilms größer als ein Neigungswinkel eines Sauerstoffoktaeders an dem oberen Abschnitt des epitaktischen Dünnfilms ist.

6. SOT-Material nach Anspruch 5, wobei
der epitaktische Dünnfilm einen Perowskit mit einer Sauerstoffoktaederstruktur enthält und ein Neigungswinkel eines Sauerstoffoktaeders an dem unteren Abschnitt des epitaktischen Dünnfilms 10° bis 45° beträgt und ein Neigungswinkel eines Sauerstoffoktaeders an dem oberen Abschnitt des epitaktischen Dünnfilms 0° beträgt.

7. SOT-Material nach einem vorhergehenden Anspruch, wobei
der epitaktische Dünnfilm eine $ABO_3$-Kristallstruktur enthält und ein Verhältnis eines Elements B zu einem Element A an dem oberen Abschnitt des epitaktischen Dünnfilms größer als ein Verhältnis des Elements B zu dem Element A an dem unteren Abschnitt des epitaktischen Dünnfilms ist.

8. SOT-Material nach einem vorhergehenden Anspruch, wobei
das Substrat ein Strontiumtitanoxid, $SrTiO_3$, enthält und der epitaktische Dünnfilm ein Strontiumrutheniumoxid, $SrRuO_3$, enthält.

9. Magnetspeichervorrichtung, umfassend:

ein Spin-Orbit-Drehmomentmaterial, SOT-Material, (100) nach einem vorhergehenden Anspruch;
eine Tunnelschicht (200) benachbart zu dem SOT-Material; und
eine fixierte Schicht (300) benachbart zu der Tunnelschicht.

10. Magnetspeichervorrichtung nach Anspruch 9, wobei
als Reaktion auf das Zuführen eines Impulsstroms zu dem SOT-Material ein geneigter Spinstrom in dem SOT-Material erzeugt wird, eine Magnetisierungsumschaltung in dem SOT-Material durch den geneigten Spinstrom erfolgt und eine Ausrichtung von Magnetisierungsvektoren in dem SOT-Material und der fixierten Schicht basierend auf der Magnetisierungsumschaltung geändert wird.


**Revendications**

1. Matériau à couple spin-orbite, SOT, (100) comprenant :

un substrat (110) ; et
un film mince épitaxial (120) comprenant une pluralité de sous-empilements ($120_n$) sur le substrat, **caractérisé en ce qu'**une structure cristalline d'un premier sous-empilement ($120_1$) parmi la pluralité de sous-empilements dans une partie inférieure du film mince épitaxial est un système orthorhombique et une structure cristalline d'un second sous-empilement parmi la pluralité de sous-empilements dans une partie supérieure du film mince épitaxial est un système tétragonal, et
la partie inférieure du film mince épitaxial est plus proche du substrat que la partie supérieure du film mince épitaxial.

2. Matériau SOT de la revendication 1,
une constante de réseau du premier sous-empilement étant supérieure à une constante de réseau d'un troisième sous-empilement adjacent au premier sous-empilement, le troisième sous-empilement étant parmi la pluralité de sous-empilements.

3. Matériau SOT de la revendication 1 ou 2, une constante de réseau de la partie inférieure du film mince épitaxial étant inférieure à une constante de réseau de la partie supérieure du film mince épitaxial.

4. Matériau SOT d'une quelconque revendication précédente,
ledit film mince épitaxial comprenant une pérovskite possédant une structure octaédrique d'oxygène et un angle d'inclinaison d'un octaèdre d'oxygène du premier sous-empilement étant supérieur à un angle d'inclinaison d'un octaèdre d'oxygène du second sous-empilement.

5. Matériau SOT d'une quelconque revendication précédente,
ledit film mince épitaxial comprenant une pérovskite possédant une structure octaédrique d'oxygène et un angle d'inclinaison d'un octaèdre d'oxygène au niveau de la partie inférieure du film mince épitaxial étant supérieur à un angle d'inclinaison d'un octaèdre d'oxygène au niveau de la partie supérieure du film mince épitaxial.

6. Matériau SOT de la revendication 5,
ledit film mince épitaxial comprenant une pérovskite possédant une structure octaédrique d'oxygène et un angle d'inclinaison d'un octaèdre d'oxygène au niveau de la partie inférieure du film mince épitaxial étant de 10° à 45° et un angle d'inclinaison d'un octaèdre d'oxygène au niveau de la partie supérieure du film mince épitaxial étant de 0°.

7. Matériau SOT d'une quelconque revendication précédente,
ledit film mince épitaxial comprenant une structure cristalline $ABO_3$ et un rapport d'un élément B à un élément A au niveau de la partie supérieure du film mince épitaxial étant supérieur à un rapport de l'élément B à l'élément A au niveau de la partie inférieure du film mince épitaxial.

8. Matériau SOT d'une quelconque revendication précédente,
ledit substrat comprenant un oxyde de strontium et de titane, $SrTiO_3$, et ledit film mince épitaxial comprenant un oxyde de strontium et de ruthénium, $SrRuO_3$.

9. Dispositif à mémoire magnétique comprenant :
un matériau à couple spin-orbite, SOT, (100) selon une quelconque revendication précédente :

une couche de tunnellisation (200) adjacente au matériau SOT ; et
une couche piégée (300) adjacente à la couche de tunnellisation.

10. Dispositif à mémoire magnétique de la revendication 9,
en réponse à la fourniture d'un courant d'impulsion au matériau SOT, un courant de spin incliné étant généré dans le matériau SOT, une commutation de magnétisation dans le matériau SOT se produisant par le courant de spin incliné, et un alignement de vecteurs de magnétisation dans le matériau SOT et ladite couche piégée étant modifiés sur la base de la commutation de magnétisation.

# FIG. 1

# FIG. 2

```
        ┌─────────┐
        │  Start  │
        └─────────┘
             │
             ▼
┌──────────────────────────────────────────────┐
│ Irradiating laser to surface of pre-prepared target │──S110
└──────────────────────────────────────────────┘
             │
             ▼
┌──────────────────────────────────────────────┐
│ Confirming stage of thin film growing on substrate │──S120
└──────────────────────────────────────────────┘
             │
             ▼
┌──────────────────────────────────────────────┐
│        Changing oxygen partial pressure       │──S130
│        and confirming stage of thin film      │
└──────────────────────────────────────────────┘
             │
             ▼
           Whether thickness of
   No    thin film or oxygen partial pressure is ──S140
           a desired and/or alternatively
               predetermined value
             │
            Yes
             ▼
        ┌─────────┐
        │   End   │
        └─────────┘
```

# FIG. 3

Beginning of Deposition

End of Deposition

RHEED intensity

High oxygen
partial pressure

Low oxygen
partial pressure

0    100    200    300    400    500    600    700    800

Time (second)

# FIG. 4

# FIG. 5

# FIG. 6

Low partial
pressure of oxygen
- Larger lattice $c_{pc}$
- Perpendicular **M**

High partial
pressure of oxygen
- Smaller lattice $c_{pc}$
- Tilted **M**

$[001]_{pc}$

$[010]_{pc}$

$[100]_{pc}$

FIG. 7

FIG. 8

# FIG. 9

# FIG. 10

# FIG. 11

<u>1100</u>

1110

1120

Input device

Output device

Processor ~1130

Memory device ~1140

Memory ~1141

# FIG. 12

# FIG. 13

<u>1300</u>

1330

1320

1310

| Host | | Memory controller | | Memory |